(19) Europäisches Patentamt

European Patent Office

Office européen des brevets

(11) **EP 1 676 939 A1**

(12) **EUROPEAN PATENT APPLICATION**

(43) Date of publication:
05.07.2006 Bulletin 2006/27

(51) Int Cl.:
*C23C 30/00* $^{(2006.01)}$

(21) Application number: 05445085.3

(22) Date of filing: 26.10.2005

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 03.01.2005 SE 0500016

(71) Applicant: **Sandvik Intellectual Property AB**
**811 81 Sandviken (SE)**

(72) Inventor: **Hessman, Ingemar**
**811 54 Sandviken (SE)**

(74) Representative: **Taquist, Henrik Lennart Emanuel**
**Sandvik Intellectual Property AB**
**811 81 Sandviken (SE)**

(54) **Coated cutting insert**

(57)    The present invention relates to cutting insert for milling of extremely highly alloyed grey cast iron comprising a substrate and a coating and method of making. The cemented carbide substrate consists of WC, 3-8 weight-% Co and <0.5 weight-% carbides of metals from groups IVb, Vb or VIb of the periodic table. The coating comprises

- a first, innermost layer of $TiC_xN_yO_z$ with x+y+z=1, y>x and z<0.2, preferably y>0.8, and z=0, with equiaxed grains with size <0.5 $\mu$m and a total thickness of 0.1-1.5 $\mu$m,
- a layer of $TiC_xN_y$ with x+y=1, x>0.3 and y>0.3, preferably x≥0.5, with a thickness of >3-5 $\mu$m with columnar grains with an average diameter of <5 $\mu$m,
- a layer of a smooth, fine-grained, grain size 0.5-2 $\mu$m, $\kappa$-$Al_2O_3$ with a thickness of 0.5-3 $\mu$m and
- an outermost layer of TiN with a thickness of <2 $\mu$m.

EP 1 676 939 A1

**Description**

The present invention relates to a coated cemented carbide insert particularly useful for dry milling of extremely highly alloyed grey cast iron in particular such cast iron further alloyed with carbide forming elements such as Cr, Ti and Mo.

US 6,177,178 discloses a coated milling insert particularly useful for milling in low and medium alloyed steels with or without raw surface zones during wet or dry conditions. The insert is characterised by a WC-Co cemented carbide with a low content of cubic carbides and a highly W-alloyed binder phase and a coating including an inner layer of $TiC_xN_yO_z$ with columnar grains, a layer of $\kappa$-$Al_2O_3$ and, preferably, a top layer of TiN.

US 6,333,098 discloses a coated cutting insert particularly useful for dry milling of grey cast iron. The insert is characterised by a WC-Co cemented carbide substrate and a coating including an innermost layer of $TiC_xN_yO_z$ with columnar grains and a top coating of a fine-grained $\alpha$-$Al_2O_3$-layer.

Grey cast-iron is a material, which, in general, is reasonably easy to machine with cemented carbide tools. Often, long tool life can be obtained. However, the machinability of cast iron can vary considerably. The tool life may be influenced significantly by small variations in the chemical composition within the material, which may be related to the casting technique used, such as the cooling conditions. Other causes for variations are the casting skin and sand inclusions, if present, or even the stability of the machine used for cutting the material.

Extremely highly alloyed cast iron is used in some types of car engines in order to obtain high strength of the engine.

With extremely highly alloyed grey cast iron is herein meant cast iron alloyed with additives such as Cr, Mo, Ti, which forms different types of carbides in the matrix. Preferably the contents of these elements are Cr >0.15, Mo >0.04, and/or Ti >0.015 wt-%.

When machining such cast irons by coated milling inserts the abrasive wear type is dominating because of the presence of the carbides. That is, fragments or individual grains of the layers and later also parts of the cemented carbide are successively pulled away from the cutting edge by the work piece chip formed. Such wear mechanism is further accelerated by the formation of cracks about 50 $\mu$m apart along and perpendicular to the cutting edge generally referred to as comb cracks. As soon as the coating is worn out, the underlying cemented carbide will wear fast. The increased specific surface contributes to higher cutting forces, increased temperature and increased chemical reaction between workpiece material and the coating/substrate.

It is an object of the present invention to provide a coated cutting tool insert with a reliable and stable tool life in mass volume production and in particular when unmanned production is employed.

It is a further object of the present invention to provide a coated cutting tool insert that can withstand or delay comb crack formation as long as possible and a coating that adheres well to the cemented carbide.

It is a further object of the present invention to provide a coated cutting tool insert with low adhesion forces between the chip and the coating and with a high internal strength.

It is a still further object of the present invention to provide a coated cutting tool insert particularly useful for milling of extremely highly alloyed cast iron.

According to the present invention a cutting tool insert is provided with a cemented carbide body of a composition 5-8 wt-% Co, preferably 5-7 wt-% Co, <0.5 wt-%, preferably 0 wt-%, cubic carbides of the metals Ti, Ta and/or Nb and balance WC. The average grain size of the WC is in the range of 1-2.5 $\mu$m. The cobalt binder phase is highly alloyed with W. The content of W in the binder phase can be expressed as the

$$CW\text{-}ratio = M_S / (wt\text{-}\% \ Co \cdot 0.0161),$$

where $M_s$ is the measured saturation magnetization of the cemented carbide body in kA/m and
wt-% Co is the weight percentage of Co in the cemented carbide. The CW-value is a function of the W content in the Co binder phase. A low CW-value corresponds to a high W-content in the binder phase.

According to the present invention improved cutting performance is achieved if the cemented carbide body has a CW-ratio of 0.75-0.93, preferably 0.80-0.90. The cemented carbide body may contain small amounts, <1 volume-%, of eta phase ($M_6C$), without any detrimental effect.

- The radius of the uncoated cutting edge is 20-50 $\mu$m, preferably about 30-40 $\mu$m.

The coating comprises

- a first, innermost layer of $TiC_xN_yO_z$ with x+y+z=1, y>x and z<0.2, preferably y>0.8, and z=0, with equiaxed grains with size <0.5 $\mu$m and a thickness of 0.1-1.5 $\mu$m,

- a layer of $TiC_xN_y$ with x+y=1, x>0.3 and y>0.3, preferably x≥0.5, with a thickness of >3-5 $\mu$m with columnar grains with an average diameter of <5 $\mu$m,
- a layer of a smooth, fine-grained, grain size about 0.5-2 $\mu$m, $Al_2O_3$ consisting essentially of the κ-phase. However, the layer may contain small amounts, 1-3 vol-%, of the θ- or the α-phases as determined by XRD-measurement. The $Al_2O_3$-layer has a thickness of 0.5-3 $\mu$m, preferably 0.5-2 $\mu$m, and most preferably 0.5-1.5 $\mu$m.
- a TiN-layer <2, preferably 0.5-1.5, $\mu$m. This outermost TiN-layer has a surface roughness $R_{max≤}0.4$ $\mu$m over a length of 10 $\mu$m at least on the cutting edge. The TiN-layer is preferably missing along the cutting edge and the underlying alumina layer may be partly or completely missing along the cutting edge.

The present invention also relates to a method of making a coated cemented carbide body of a composition 5-8 wt-% Co, preferably 5-7 wt-% Co, <0.5 wt-%, preferably 0 wt-%, cubic carbides of the metals Ti, Ta and/or Nb and balance WC. The average grain size of the WC is in the range of 1-2.5 $\mu$m. The cobalt binder phase is highly alloyed with W. The content of W in the binder phase expressed as CW-ratio is 0.75-0.93, preferably 0.80-0.90.

The uncoated cutting edge is provided with an edge radius of 20-50 $\mu$m, preferably about 30-40 $\mu$m.

The coating comprises:

- a first, innermost layer of $TiC_xN_yO_z$ with x+y+z=1, y>x and z<0.2, preferably y>0.8, and z=0, with equiaxed grains with size <0.5 $\mu$m and a thickness of 0.1-1.5 $\mu$m, using known CVD-methods
- a layer of $TiC_xN_y$ with x+y=1, x>0.3 and y>0.3, preferably x≥0.5, with a thickness of >3-5 $\mu$m with columnar grains with an average diameter of <5 $\mu$m, deposited by MTCVD-technique, using acetonitrile as the carbon and nitrogen source for forming the layer in the temperature range of 700-900 °C
- a layer of a smooth, fine-grained, grain size about 0.5-2 $\mu$m, κ-$Al_2O_3$ with a thickness of 0.5-3 $\mu$m, preferably 0.5-2 $\mu$m, most preferably 0.5-1.5 $\mu$m, according to known CVD-technique and
- a <2, preferably 0.5-1.5, $\mu$m, thick TiN-layer using known CVD-methods. This outermost TiN-layer is preferably brushed with e.g. a SiC based brush to a surface roughness $R_{max≤}0.4$ $\mu$m over a length of 10 $\mu$m at least on the cutting edge. The TiN-layer is preferably removed along the cutting edge and the underlying alumina layer may be partly or completely removed along the cutting edge.

The present invention also relates to the use of inserts according to above for dry milling of extremely highly alloyed cast iron, preferably containing Cr >0.15, Mo >0.04, and/or Ti >0.015 wt-% at a cutting speed of 70-220 m/min and a feed of 0.15-0.35 mm/tooth depending on cutting speed and insert geometry.

Example 1

A) Cemented carbide milling inserts in accordance with the invention with the composition 6.0 wt-% Co and balance WC were sintered in a conventional way at 1410°C and cooled down to 1200°C in 0.6 bar $H_2$ giving inserts with a binder phase alloyed with W, corresponding to a CW-ratio of 0.89. The average WC grain size was 1.3 $\mu$m. After conventional edge rounding-treatment to an edge radius of 35 $\mu$m, the inserts were coated with a 0.5 $\mu$m equiaxed Ti(C,N)-layer with a high nitrogen content corresponding to an estimated C/N-ratio of 0.05 followed by a 4 $\mu$m thick Ti(C,N)-layer with columnar grains using MTCVD-technique at a temperature of 885-850 °C and with $CH_3CN$ as the carbon and nitrogen source. In subsequent steps during the same coating cycle a 1.0 $\mu$m thick layer of $Al_2O_3$ was deposited using a temperature of 970 °C and a concentration of $H_2S$ dopant of 0.4 weight-% as disclosed in EP-A-523 021. Finally, a 1.0 $\mu$m layer of TiN was deposited on top according to known CVD-technique. XRD-measurement showed that the $Al_2O_3$-layer consisted of 100 % κ-phase. The cemented carbide body had a WC grain size in average of 1.8 $\mu$m. The coated inserts were dry brushed by a nylon straw brush containing SiC grains. Examination of the brushed inserts in a light microscope showed that the thin TiN-layer had been brushed away only along the cutting edge leaving there a smooth $Al_2O_3$-layer surface. Coating thickness measurements on cross-sectioned brushed samples showed no reduction of the coating along the edge line except for the outer TiN-layer that was removed.

Example 2

Inserts according to the present invention were tested in face milling of engine blocks in highly alloyed "Grauguss" GG25, a highly alloyed cast iron containing 0.42 wt-% Cr and 0.03 wt-% Ti.
Tool: Sandvik Coromant R260.31-315
Number of inserts: 50 PCs

Criterion: Surface finish and work piece frittering.
Reference: TNEF 1204EN competitor grade
Cutting data
Cutting speed: Vc = 187 m/min
Feed per tooth: Fz= 0.17mm per tooth
Depth of cut: Ap=4 mm
Dry conditions
Tool life reference: 460 cylinder blocks in production.
Tool life of invention: 613 cylinder heads.
Average of five tests.

The test shows an increase of tool life of 33 % with improved surface finish and productivity.


Example 3

Inserts according to the present invention were tested in face milling of engine blocks in extremely highly alloyed grey cast iron GL04+CR, a highly alloyed cast iron containing 0.35 wt-% Cr.
Tool: Sandvik Coromant R260.31-250
Number of inserts: 40 PCs
Criterion: Surface finish and work piece out of tolerance.
Reference: TNEF 1204AN-CA in grade GC3020 from Sandvik Coromant
Cutting data
Cutting speed: Vc = 126 m/min
Feed per tooth: Fz= 0.2 mm per tooth
Depth of cut: Ap=3.5 mm
Dry conditions
Tool life with reference: 1100 cylinder blocks in production.
Tool life of invention: 1745 cylinder heads.
Average of five tests.

The test shows an increase of tool life of 58 % with improved surface finish and tolerances.


**Claims**

1.   Cutting insert for milling of extremely highly alloyed grey cast iron comprising a substrate and a coating **characterised in that** said substrate comprises WC with an average grain size of 1-2.5 $\mu$m, 5-8 wt-% Co, preferably 5-7 wt-% Co, and <0.5 wt-% cubic carbides of metals Ta, Ti and or Nb and a highly W-alloyed binder phase with a CW-ratio of 0.75-0.93 with <1 vol-% eta-phase and **in that** said coating comprises

 - a first, innermost layer of $TiC_xN_yO_z$ with x+y+z=1, y>x and z<0.2, preferably y>0.8 and z=0, with equiaxed grains with size <0.5 $\mu$m and a total thickness of 0.1-1.5 $\mu$m,
 - a layer of $TiC_xN_y$ with x+y=1, x>0.3 and y>0.3, preferably x$\geq$0.5, with a thickness of >3-5 $\mu$m with columnar grains with an average diameter of <5 $\mu$m,
 - a layer of a smooth, fine-grained, grain size 0.5-2 $\mu$m, $\kappa$-$Al_2O_3$ with a thickness of 0.5-3 $\mu$m, preferably 0.5-2 $\mu$m, and
 - an outermost layer of TiN with a thickness of <2, preferably 0.5-1.5, $\mu$m.

2.   Milling insert according to the preceding claim **characterized in that** the outermost TiN-layer has a surface roughness $R_{max\leq}$0.4 $\mu$m over a length of 10 $\mu$m.

3.   Milling insert according to any of the preceding claims **characterized in that** the outermost TiN-layer is missing along the cutting edge.

4.   Milling insert according to any of the preceding claims **characterized in that** the radius of the uncoated cutting edge is 20-50 $\mu$m, preferably about 30-40 $\mu$m.

5.   Method of making a milling insert comprising a substrate and a coating **characterised in** providing a cemented carbide body consisting of WC with an average grain size of 1-2.5 $\mu$m, 5-8 wt-% Co, preferably 5-7 wt-% Co, and <0.5 wt-% cubic carbides of the metals Ta, Ti and or Nb and a highly W-alloyed binder phase with a CW-ratio of 0.75-0.93 with <1 vol-% eta-phase the method further comprising the steps of depositing:

- a first, innermost layer of $TiC_xN_yO_z$ with $x+y+z=1$, $y>x$ and $z<0.2$, preferably $y>0.8$ and $z=0$, with equiaxed grains with size <0.5 $\mu$m and a thickness of 0.1-1.5 $\mu$m, using known CVD-methods
- a layer of $TiC_xN_y$ with $x+y=1$, $x>0.3$ and $y>0.3$, preferably $x\geq0.5$, with a thickness of >3-5 $\mu$m with columnar grains with an average diameter of <5 $\mu$m, deposited by MTCVD-technique using acetonitrile as the carbon and nitrogen source for forming the layer in the temperature range of 700-900 °C
- a layer of a smooth, fine-grained, grain size 0.5-2 $\mu$m, $\kappa$-$Al_2O_3$ with a thickness of 0.5-3 $\mu$m, preferably 0.5-2 $\mu$m, most preferably 0.5-1.5 $\mu$m, according to known CVD-technique and
- an outermost layer of TiN with a thickness of <2, preferably 0.5-1.5 $\mu$m, using known CVD-methods.

6. Method according to claim 5 **characterized in that** the outermost TiN-layer is brushed with e.g. a SiC based brush to a surface roughness $R_{max}\leq0.4$ $\mu$m over a length of 10 $\mu$m.

7. Method according to any of claims 5 or 6 **characterized in that** the outermost TiN-layer is removed by brushing along the cutting edge.

8. Method according to any of claims 5, 6 or 7 **characterized in** providing the uncoated cutting edge with a radius of 20-50 $\mu$m, preferably about 30-40 $\mu$m.

9. Use of inserts according to claims 1-4 for dry milling of extremely highly alloyed cast iron, preferably containing Cr >0.15, Mo >0.04, and/or Ti >0.015 wt-%, at a cutting speed of 70-220 m/min and a feed of 0.15-0.35 mm/tooth depending on cutting speed and insert geometry.

**European Patent Office**

## EUROPEAN SEARCH REPORT

Application Number

EP 05 44 5085

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 01/16389 A (SANDVIK AB) 8 March 2001 (2001-03-08) * page 6, line 9 - line 26; claims 1-8 * | 1-3,5-7, 9 | C23C30/00 |
| X | US 6 261 673 B1 (REINECK INGRID ET AL) 17 July 2001 (2001-07-17) * column 3, line 6 - line 31; claims 1-20 * | 1-3,5-7, 9 | |
| X | EP 0 874 919 B (SANDVIK AKTIEBOLAG) 13 February 2002 (2002-02-13) * paragraph [0014]; claims 1-8 * | 1-3,5-7, 9 | |
| Y | EP 0 753 603 B (SANDVIK AKTIEBOLAG) 12 January 2000 (2000-01-12) * page 3, paragraph 12; claims 1-6 * | 1-3,5-7, 9 | |
| Y | US 2004/033393 A1 (NORDGREN ANDERS ET AL) 19 February 2004 (2004-02-19) * claims 1-12 * | 1-3,5-7, 9 | |
| A | EP 0 709 484 B (MITSUBISHI MATERIALS CORPORATION) 14 April 1999 (1999-04-14) * claims 1-3,7 * | 1-3,5-7, 9 | TECHNICAL FIELDS SEARCHED (IPC)<br><br>C23C |
| A | US 2002/051886 A1 (BLOMSTEDT PER ET AL) 2 May 2002 (2002-05-02) * claims 1-8 * | 1,5 | |
| A | PATENT ABSTRACTS OF JAPAN vol. 013, no. 472 (C-647), 25 October 1989 (1989-10-25) & JP 01 184218 A (MAZDA MOTOR CORP), 21 July 1989 (1989-07-21) * abstract * | 4,8 | |
| A | US 5 074 721 A (KRESS ET AL) 24 December 1991 (1991-12-24) * column 4, line 26 - line 29 * | 4,8 | |

The present search report has been drawn up for all claims

| Place of search | Date of completion of the search | Examiner |
|---|---|---|
| The Hague | 23 February 2006 | Elsen, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 44 5085

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2006

| Patent document cited in search report | | Publication date | Patent family member(s) | | Publication date |
|---|---|---|---|---|---|
| WO 0116389 | A | 08-03-2001 | AT | 286152 T | 15-01-2005 |
| | | | DE | 60017161 D1 | 03-02-2005 |
| | | | DE | 60017161 T2 | 08-12-2005 |
| | | | EP | 1218558 A1 | 03-07-2002 |
| | | | IL | 147780 A | 25-07-2005 |
| | | | JP | 2003508632 T | 04-03-2003 |
| | | | US | 6406224 B1 | 18-06-2002 |
| US 6261673 | B1 | 17-07-2001 | EP | 1100979 A1 | 23-05-2001 |
| | | | JP | 2002520175 T | 09-07-2002 |
| | | | WO | 0003062 A1 | 20-01-2000 |
| EP 0874919 | B | 13-02-2002 | AT | 213283 T | 15-02-2002 |
| | | | BR | 9611781 A | 23-02-1999 |
| | | | CN | 1203637 A | 30-12-1998 |
| | | | DE | 69619275 D1 | 21-03-2002 |
| | | | DE | 69619275 T2 | 24-06-2004 |
| | | | EP | 0874919 A1 | 04-11-1998 |
| | | | IL | 124475 A | 26-08-2001 |
| | | | JP | 2000515588 T | 21-11-2000 |
| | | | WO | 9720082 A1 | 05-06-1997 |
| | | | US | 6200671 B1 | 13-03-2001 |
| EP 0753603 | B | 12-01-2000 | AT | 188751 T | 15-01-2000 |
| | | | BR | 9603066 A | 01-10-2002 |
| | | | CN | 1142421 A | 12-02-1997 |
| | | | DE | 69606109 D1 | 17-02-2000 |
| | | | DE | 69606109 T2 | 31-05-2000 |
| | | | EP | 0753603 A2 | 15-01-1997 |
| | | | IL | 118791 A | 26-01-1999 |
| | | | JP | 9029512 A | 04-02-1997 |
| | | | SE | 514177 C2 | 15-01-2001 |
| | | | SE | 9502640 A | 15-01-1997 |
| | | | US | 5863640 A | 26-01-1999 |
| US 2004033393 | A1 | 19-02-2004 | NONE | | |
| EP 0709484 | B | 14-04-1999 | DE | 69509035 D1 | 20-05-1999 |
| | | | DE | 69509035 T2 | 09-09-1999 |
| | | | EP | 0709484 A1 | 01-05-1996 |
| | | | KR | 187369 B1 | 01-04-1999 |
| | | | US | 5652045 A | 29-07-1997 |
| US 2002051886 | A1 | 02-05-2002 | NONE | | |
| JP 01184218 | A | 21-07-1989 | NONE | | |

EPO FORM P0459

For more details about this annex : see Official Journal of the European Patent Office, No. 12/82

EP 1 676 939 A1

## ANNEX TO THE EUROPEAN SEARCH REPORT
## ON EUROPEAN PATENT APPLICATION NO.

EP 05 44 5085

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2006

| Patent document cited in search report | | Publication date | Patent family member(s) | | Publication date |
|---|---|---|---|---|---|
| US 5074721 | A | 24-12-1991 | BR | 8103486 A | 24-02-1982 |
| | | | CS | 8103921 A2 | 14-08-1989 |
| | | | DD | 159303 A1 | 02-03-1983 |
| | | | DE | 3020929 A1 | 10-12-1981 |
| | | | EP | 0041266 A1 | 09-12-1981 |
| | | | ES | 258752 Y | 01-01-1984 |
| | | | JP | 57021211 A | 03-02-1982 |
| | | | PL | 231338 A1 | 23-12-1981 |
| | | | SU | 1192598 A3 | 15-11-1985 |

EPO FORM P0459

For more details about this annex : see Official Journal of the European Patent Office, No. 12/82

8